## Europäisches Patentamt
## European Patent Office
## Office européen des brevets

(19)

(11) Veröffentlichungsnummer: **0 105 398**
**B1**

(12) # EUROPÄISCHE PATENTSCHRIFT

(45) Veröffentlichungstag der Patentschrift:
22.07.87

(21) Anmeldenummer: **83109248.1**

(22) Anmeldetag: **19.09.83**

(51) Int. Cl.⁴: **C 08 F 2/44,** C 08 K 5/00,
H 01 L 31/02

(54) Verfahren zur Herstellung von Lichtsammlern.

(30) Priorität: **30.09.82 DE 3236241**

(43) Veröffentlichungstag der Anmeldung:
**18.04.84 Patentblatt 84/16**

(45) Bekanntmachung des Hinweises auf die Patenterteilung:
**22.07.87 Patentblatt 87/30**

(84) Benannte Vertragsstaaten:
**DE FR GB IT**

(56) Entgegenhaltungen:
**EP-A-0 025 136**
**DE-A-2 851 513**

**ULLMANNS ENCYCLOPÄDIE DER TECHNISCHEN CHEMIE, Bd. 19 (4. Aufl. 1980), Seiten 22, 23.**

(73) Patentinhaber: **BAYER AG, Konzernverwaltung RP Patentabteilung, D-5090 Leverkusen 1 Bayerwerk (DE)**

(72) Erfinder: **Claussen, Uwe, Dr., Carl- Rumpff-Strasse 29, D-5090 Leverkusen 1 (DE)**
Erfinder: **Merten, Josef, Dr., Krünsend 30, D-4052 Korschenbroich 1 (DE)**
Erfinder: **Röhr, Harry, Dr., Zur Ville 21, D-5020 Frechen 4 (DE)**
Erfinder: **Melchior, Bernd, Dipl.- Chem., Burger Strasse 255, D-5630 Remscheid (DE)**

EP 0 105 398 B1

**0 105 398**

**Beschreibung**

Die Erfindung betrifft ein Verfahren zur Herstellung von Lichtsammlern aus einem transparenten Kunststoff, der mit fluoreszenzfähigen, das Sonnenlicht absorbierenden Stoffen dotiert ist.

Lichtsammler, z. B. Platten aus einem transparenten, Fluoreszenzfarbstoffe enthaltenden Kunststoff zum Sammeln von direktem oder diffusen Licht sind prinzipiell bekannt (vergl. DE-OS 26 20 115, US-PS 4 149 902 und Solar Cells 4 (1981), 3-23).

Die technische Brauchbarkeit solcher Lichtsammler ist von ihrem Energiewirkungsgrad abhängig, dem Verhältnis von nutzbarer elektrischer Energie zur Energie der angebotenen Lichtstrahlung. Der Energiewirkungsgrad wird u.a. vom Reflektionsvermögen der Sammleroberfläche, der Absorption der Lichtstrahlung durch den Farbstoff, der Streuung des emittierten Lichts durch Reabsorption oder optische Inhomogenität der Matrix und Verlusten bei der Umwandlung des Lichts in elektrische Energie bestimmt.

Bei den Lichtsammlern mit Fluoreszenzfarbstoffen ist der Intensitätsverlust des Fluoreszenzlichtes beim Transport des Lichts aus der Platte an ihre Kante besonders kritisch. Reinheit des Farbstoffs und eine möglichst hohe Bandentrennung schaffen hier günstige Voraussetzungen.

Die Farbstoffe lassen sich z. B. durch fraktionierte Kristallisation, Adsorptions- oder Verteilungschromatographie an festen oder flüssigen Trägern ausreichend reinigen. Die Bandentrennung ist dagegen wesentlich von den Eigenschaften des Umfelds der Farbstoffe abhängig. Beispielsweise wurde versucht, durch niedermolekulare Zusätze die Bandentrennung zu verbessern (Appl. Phys. 23, 369 (1980). Dann wird aber die Lebensdauer des Lichtsammlers durch Ausbluten des niedermolekularen Zusatzes oder durch lichtinduzierte Reaktionen so vermindert, daß er nicht mehr technisch verwendet werden kann. Die übliche Einarbeitung von Farbstoffen in Kunststoffe durch Extrusion ergibt Produkte mit mäßigen Eigenschaften, die ebenfalls technisch nicht brauchbar sind.

Die DE-A-28 51 513 beschreibt Lichtsammler aus einem optischen Kunststoff, der eine fluoreszierenden Farbstoff enthält, z. B. gegossene Platten aus Polymethacrylat, in das ein Perylenfarbstoff eingearbeitet worden ist. Aus Ullmanns Encyklopädie der technischen Chemie, Bd. 19 (4. Auflage 1980), S. 22, 23, ist es bekannt, bei der Substanzpolymerisation von Methylmethacrylat anstelle des Monomeren eine durch Vorpolymerisation erhaltene Monomer-Polymer-Lösung einzusetzen, wodurch eine bessere Pigmentdispergierung erreicht wird.

Gegenstand der Erfindung ist ein Verfahren zur Herstellung eines Lichtsammlers aus einem klardurchsichtigen Kunststoff, der einen fluoreszierenden Farbstoff enthält, das dadurch gekennzeichnet ist, daß man klardurchsichtige Kunststoffe liefernde Monomere in Masse bei Temperaturen von 50 bis 160°C und Drucken von 2 bis 20 bar mit Hilfe von Percarbonaten, Acylsulfonylperoxyden, Perketonen oder Azodiisobuttersäureester als radikalischen Initiatoren vorpolymerisiert, vor, während oder am Ende der Vorpolymerisation den Fluoreszenzfarbstoff zugibt, und das Gemisch unter Zugabe eines weiteren Initiators aus der Gruppe Percarbonate, Acylsulfonylperoxyde, Perketone, Azoisobuttersäurenitril oder -ester, Hydroperoxyde und Perketale ebenfalls bei Drucken von 2 bis 20 bar und Temperaturen von 50 bis 160°C zu Ende polymerisiert. Man muß also ein zweistufiges Masse-Polymerisationsverfahren anwenden, bei dem man zuerst ein Prepolymer herstellt und gegebenenfalls nach Zugabe eines anderen Katalysators zu Ende polymerisiert.

Die so erhaltenen Lichtsammler haben in Vergleich zu konventionell hergestellen Produkten eine höhere Emission bei gleicher Extinktion, d.h. einen verbesserten Energiewirkungsgrad und eine größere Lebensdauer.

Bei einer gegebenen Konzentration steigt die Fluoreszenzlebensdauer eines Farbstoffs, der in einer polymeren Matrix eingebaut ist, mit der Emissionswellenlange an. Der Anstieg ist im Gebiet der Überlappung von Fluoreszenz- und Absorptionsbande stärker als im langwelligen Bereich der Emission. Hier ist die Fluoreszenzlebensdauer ca. 2 bis 10 ns, je nach Farbstoff. In den erfindungsgemäßen Lichtsammlern ist die Abklingkurve der Emission bei allen Emissionswellenlängen einexponentiell, d.h., es ist nur ein einziger emittierender Zustand nachweisbar. Nach 100 h Belichtungsdauer mit einer Xenonlampe vermindert sich die Lebensdauer der Fluoreszenz um höchstens 10 %. Dies läßt sich mit Ultrakurzzeitspektren bestimmen, die mit einem käuflichen Gerät, z. B. der Firma Ortec, aufgenommen werden können.

Die zur Herstellung der Lichtsammler erforderliche Polymerisation wird in zwei Stufen durchgeführt. Die Monomeren werden zuerst vorpolymerisiert. Als Katalysatoren für diese Stufe sind Percarbonate, Acylsulfonylperoxide, Perketone und Azodiisobuttersäureester besonders geeignet. Vor, während oder am Ende dieser Vorpolymerisation, d.h., vor Beginn der zweiten Polymerisationsstufe wird der Fluoreszenzfarbstoff zugegeben, und dann unter Zugabe eines weiteren Katalysators zu Ende polymerisiert. Für diese Stufe sind Percarbonate, Acylsulfonylperoxide, Perketone, Azoisobuttersäurenitril- oder -ester, Hydroperoxide und Perketale besonders geeignet.

Die eingesetzte Menge an Katalysator beträgt 0,1 bis 0,001 Gew.-%, bevorzugt 0,01 Gew.-%, bezogen auf Monomere, für jede Stufe. Als Polymere kommen solche in Betracht, die für Licht einer Wellenlänge von 300 bis 1000 nm verlustarm durchlässig sind, z. B. Homo- und Copolymerisate der Acrylsäure, Methacrylsäure, des Styrols oder Styrol/Acrylnitril. Die Ester der Acryl- und Methacrylsäure sind bevorzugt. Ganz besonders geeignete Acrylpolymere haben einen Restmonomerengehalt von < 0,5 %, eine Schultz'sche Uneinheitlichkeit $U_n \sim 1$, eine zahlengemittelte Molmasse $M_n \sim$ 200 000 g/Mol, eine gewichtsgemittelte Molmasse $M_w \sim$ 400 000 g/Mol, einen Staudinger Index $[\eta]$ 1,5 dl/g und möglichst wenig Langkettenverzweigung.

Die Anwendung von 2 bis 20 bar Druck bei der Polymerisation bei Temperaturen von 50 bis 160°C ist

2

erforderlich; besonders geeignet ist der Druckbereich 8 bis 12 bar und der Temperaturbereich zwischen 80 und 140°C.

Die erfindungsgemäß verwendbaren fluoreszierenden Farbstoffe kennzeichnet ein großes Stokes-shift. Besonders geeignet sind Farbstoffe aus der Thioxanthen- oder Cumarinreihe oder Derivate des Perylens oder Bor-Komplexverbindungen, wie sie beispielsweise in den Deutschen Offenlegungsschriften 28 51 513, 28 17 456, 30 01 877, 29 52 228 (& EP-A-00 25 136), 29 37 422, 26 07 968 und der FR-PS-1 488 113 beschrieben sind.

Die Menge der Farbstoffe ist zwischen 0,001 und 0,5 Gew.-%, bezogen auf Polymer; bevorzugt ist eine Menge von 0,01-0,1 Gew.-% oder $\sim 10^{-3} - 10^{-4}$ Mol.

Der Lichtsammler kann unter Zuhilfenahme an sich bekannter Hilfsstoffe zur Verbesserung des Polymerisationsablaufs, wie beispielsweise Butylacrylat oder Ethylenglykoldimethacrylat, hergestellt werden. Es ist vorteilhaft, neutrale oder saure Verbindungen für diesen Zweck zu verwenden. Vorteilhaft ist der Einbau von Methacrylsäure oder Acrylsäure in Mengen bis zu 5 %, oder die Mitverwendung von Paraffincarbonsäuren wie Stearinsäure, von Sulfimiden oder Styrolsulfonsäuren. Sie werden zweckmäßig in Mengen zwischen 0,01 und 5 % zugegeben.

Die Lichtsammelplatten können in Verbindung mit photovoltaischen Elementen zur Nutzbarmachung der Sonnenenergie Verwendung finden. Prinzipiell kann jedes photovoltaische Element zur Umwandlung des konzentrierten Lichts in elektrische Energie verwendet werden, dessen Leitfähigkeitsband mit dem Emissionsgebiet des Feststoffs überlappt. Besonders geeignet sind Si oder Ga-As-Zellen. Eine optimale Wirkung erhält man, wenn photovoltaisches Element und Farbstoff aufeinander abgestimmt sind. Eine besonders bevorzugte Kombination ist die Ga-As-Zelle mit orange-gelb fluoreszierenden Farbstoffen aus der Reihe der Perylentetracarbonsäurediimide oder mit rot fluoreszierenden Farbstoffen aus der Cumarin- oder Thioxanthen-Reihe. Darüber hinaus eignen sich die erfindungsgemäßen Lichtsammler in der Verbindung mit elektronischen Steuerungen als Anzeigevorrichtungen mit sehr geringem Energieverbrauch oder ohne elektronische Bauteile für vielerlei Anzeige-, Hinweis- und Markierungszwecke, z. B. in passiven Anzeigeelementen, Hinweis- und Verkehrszeichen, wie Ampeln.

Die erfindungsgemäßen Lichtsammler werden vorwiegend als Platten verwendet, jedoch können auch andere geometrische Formen infrage kommen.

Die erfindungsgemäßen Lichtsammler zeichnen sich durch besonders gutes Lichtleitvermögen und durch hohe Stabilisierung der Farbstoffe aus. Diese beiden Eigenschaften sind für die technische Verwendung essentiell. Das erfindungsgemäße Material ist spritzgußfähig; seine guten optischen und spektralen Eigenschaften werden bei dieser Verarbeitung nur wenig beeinflußt und sind deutlich besser als die konventionell hergestellter Produkte.

## BEISPIELE

### Beispiel 1

a) 110 g Methylmethacrylat werden mit 0,1 % Azo-bis(ethylisobutyrat) bei 95°C bis zu einer Viskosität von ca. 1 000 mPa.s vorpolymerisiert. Man gibt jetzt 11 mg Tetrachlor-N-Methylperylen-tetracarbonsäurediimid hinzu, sorgt für vollständige Auflösung und Durchmischung und führt die Reaktion unter Zugabe von 11 mg Bis(Cyclohexyl-)percarbonat und 11 mg Azo-bis-buttersäurenitril bei 140°C und 10 bar Druck zu Ende. Man erhält ein glasklares, gelb fluoreszierendes Produkt mit folgenden Daten (Spalte 1).

|  | 1. | 2. |  |
|---|---|---|---|
| Staudinger-Index | 0,97 | 1,40 | dl/g |
| M | 178000 | 258000 | g/Mol |
| $M_w$ | 413000 | 389000 | g/Mol |
| Uneinheitlichkeit | 1,3 | 0,151 |  |
| Restmonomer | < 0,5 % | < 0,5 % |  |

b) Verfährt man wie vorstehend und setzt dem Vorpolymerisat 5 % Butylacrylat und 0,1 % Methacrylsäure zu, so erhält man ein Produkt mit den Daten der Spalte 2.

### Beispiel 2

110 g Methylmethacrylat werden mit 0,1 % Azo-bis-isobutyrat in Gegenwart von 11 mg 3-Benzthiazolyl-4-cyano-7-Diethylamino-cumarin vorpolymerisiert, bis die Zähigkeit etwa 1000 mPa.s erreicht hat. Man gibt jetzt 0,1 % Methylisopropylperketon hinzu und führt die Reaktion bei 140°C und 10 bar Druck zu Ende.

Man erhält ein klares, tiefrot fluoreszierendes Material, in dem der Farbstoff im Emissionsmaximum bei 594 nm eine Lebensdauer der Fluoreszenz von 8,35 ns aufweist. Der gleiche Farbstoff in gleicher Konzentration-in handelsübliches Granulat eingearbeitet hat eine Lebensdauer der Fluoreszenz von 6,98 ns die absolute integrierte Fluoreszenz beträgt $4,16 \cdot 10^5$.

**Beispiel 3**

5 kg des nach Beispiel 1 a) erhaltenen Materials werden gebrochen und durch Klassieren auf eine Korngröße von 5 mm gebracht. Dieses Granulat wird durch Spritzgut zu Plättchen vom Format 50 x 30 x 2 mm verarbeitet. Die spektroskopischen Eigenschaften sind in Tabelle 1, Zeile 1 wiedergegeben. Spektroskopische Daten des Materials gemäß Beispiel 1 a) ohne Spritzgußverarbeitung sind Zeile 2 zu entnehmen.

Zum Vergleich wird auf handelsübliches Polymethylmethacrylat (Plexiglas N 7, Rohm) der gleich Farbstoff in gleicher Menge aufgebracht, das Produkt durch Spritzguß verarbeitet (Zeile 3) und noch einmal gebrochen und wieder einem Spritzgußverfahren unterworfen (Zeile 4).

Die beiden Probenpaare haben folgende Eigenschaften:

**Tabelle 1**

| Absorption Extinktion | Wellenzahl | Emission abs. Intensität | Integrationsbereich |
|---|---|---|---|
| 1 1,03 | 18 100 | $3,47 \cdot 10^5$ | 19 000 - |
| 2 0,98 | 18 100 | $3,56 \cdot 10^5$ | 12 500 cm$^{-1}$ |
| 3 1,09 | 18 100 | $3,20 \cdot 10^5$ | |
| 4 1,09 | 18 100 | $3,08 \cdot 10^5$ | |

Man erkennt: Die Verarbeitung durch Spritzguß beeinflußt das Material 2 wenig, das Vergleichsmaterial 3 dagegen stark. Das erfindungsgemäße Material 2 ist um etwa 20 % besser als das herkömmliche Material 3.

**Beispiel 4**

Man verfährt wie in Beispiel 2 angegeben und verwendet als Farbstoffe:
1. 3(5-Chlor)benzooxazolyl-4-cyano-7-diethylamino-cumarin (Farbstoff A);
2. 3-(5-methoxy)benzthiazolyl-7-phenylsulfamido-cumarin (Farbstoff B);
3. Perylen-3.9-dicarbonsäure-isobutylester (Farbstoff C);
4. 3-(5-methoxy)benzthiazolyl-4-cyano-7-methoxy-cumarin (Farbstoff D).

Als Vergleich werden die Farbstoffe A - D drucklos nach dem herkömmlichen Polymerisationsverfahren eingebaut und die Reaktionswärme durch Wasserkühlung abgeführt.

Man erhält 2 Sätze glasklarer, tiefgefärbter Polymerisate, aus denen 1 m lange, 5 cm breite und 3 cm dicke Probekörper geschnitten werden. Diese werden an einer Schmalseite poliert und mit einer Photozelle verbunden. Bei völlig abgedecktem Probestreifen zeigt die Zelle keinen Strom an. Zieht man die Abdeckung seitlich ab, so daß Licht konstanter Intensität auf die Fläche des Probekörpers fällt, so steigt der Photostrom im Detektor kontinuierlich mit zunehmender Sammelfläche an. Der gemessene Photostrom, aufgetragen gegen die freie beleuchtete Oberfläche, liefert ein Intensitäts/Weg-Diagramm, das sich durch die Beziehung $\ln I (X) = \ln I_0 - \alpha X$ darstellen läßt. I ist der gemessene Photostrom, $I_0$ ist der Photostrom bei unendlicher Stablänge, $\alpha$ ein Dämpfungskoeffizient und X die freigelegte Weglänge. Durch bekannte mathematische Verfahren kann man durch Kurvenanpassung $I_0$ und $\alpha$ errechnen.

Man erhält:

| Farbstoff | Verfahren lt. Anspruch | | Vergleich | |
|---|---|---|---|---|
| | $I_o$ | $\alpha$ | $I_o$ | $\alpha$ |
| A | 41,2 | 0,034 | 37,4 | 0,041 |
| B | 16,0 | 0,035 | 14,2 | 0,040 |
| C | 22,7 | 0,036 | 18,6 | 0,041 |
| D | 28,1 | 0,032 | 26,6 | 0,041 |

Man sieht, daß nach dem anspruchsgemäßen Verfahren hergestelltes Material sowohl geringere Dämpfungskoeffizienten als auch einen höheren $I_o$-Wert aufweist.

**Patentansprüche**

1. Verfahren zur Herstellung eines Lichtsammlers aus einem klardurchsichtigen Kunststoff, der einen fluoreszierenden Farbstoff enthält, dadurch gekennzeichnet, daß man klardurchsichtige Kunststoffe liefernde Monomere in Masse bei Temperaturen von 50 bis 160°C und Drucken von 2 bis 20 bar mit Hilfe von Percarbonaten, Acylsulfonylperoxyden, Perketonen oder Azodiisobuttersäureester als radikalischen Initiatoren vorpolymerisiert, vor, während oder am Ende der Vorpolymerisation den Fluoreszenzfarbstoff zugibt, und das Gemisch unter Zugabe eines weiteren Initiators aus der Gruppe Percarbonate, Acylsulfonylperoxyde, Perketone, Azoisobuttersäurenitril oder -ester, Hydroperoxyde und Perketale ebenfalls bei Drucken von 2 bis 20 bar und Temperaturen von 50 bis 160°C zu Ende polymerisiert.

2. Verfahren nach Anspruch 1, dadurch gekennzeichnet, daß als Fluoreszenzfarbstoffe Cumarinderivate oder Perylenverbindungen verwendet werden.

3. Verwendung des Lichtsammlers nach Anspruch 1 in Kombination mit einem photovoltaischen Element, vorzugsweise auf Basis Ga/As oder Si.

**Claims**

1. Process for the production of a light collector from a transparent plastic containing a fluorescent dye, characterised in that monomers which form transparent plastics are massprepolymerised at temperatures of 50 to 160°C and under pressures of 2 to 20 bars with the aid of percarbonates, acylsulphonyl peroxides, perketones or azodiisobutyric acid esters as radical initiators, the fluorescent dye is added before, during or at the end of the prepolymerisation, and the mixture is polymerised to completion with the addition of a further initiator from the group comprising percarbonates, acylsulphonyl peroxides, perketones, azoisobutyronitrile or azoisobutyric acid esters, hydroperoxides and perketals, also under pressures of 2 to 20 bars and temperatures of 50 to 160°C.

2. Process according to Claim 1, characterised in that coumarin derivatives or perylene compounds are used as the fluorescent dyes.

3. Use of the light collector according to Claim 1 in combination with a photovoltaic element, preferably based on Ga/As or Si.

**Revendications**

1. Procédé de production d'un collecteur de lumière en une matière plastique transparente qui contient un colorant fluorescent, caractérisé en ce qu'on prépolymérise des monomères donnant des matières plastiques transparentes, en masse à des températures de 50 à 160°C et à des pressions de 2 à 20 bars au moyen de percarbonates, de peroxydes d'acylsulfonyle, de percétones ou d'esters d'acide azodiisobutyrique comme initiateurs radicalaires, on ajoute le colorant fluorescent avant la prépolymérisation, pendant ou à la fin, et on achève la polymérisation du mélange avec addition d'un autre initiateur du groupe des percarbonates, des peroxydes d'acylsulfonyle, des percétones, du nitrile ou d'un ester de l'acide azoisobutyrique, des hydroxyperoxydes et des percétals, également à des pressions de 2 à 20 bars et à des températures de 50 à 160°C.

2. Procédé suivant la revendication 1, caractérisé en ce qu'on utilise comme colorants fluorescents des dérivés de la coumarine ou des composés du pérylène.

3. Utilisation du collecteur de lumière suivant la revendication 1 conjointement avec un élément photovoltaïque, de préférence à base de Ga/As ou Si.